Europäisches Patentamt

European Patent Office

Office européen des brevets

(19)

(11) EP 0 589 756 B1

(12) FASCICULE DE BREVET EUROPEEN

(45) Date de publication et mention
de la délivrance du brevet:
27.08.1997 Bulletin 1997/35

(51) Int Cl.6: G01R 33/30, G01R 33/60

(21) Numéro de dépôt: 93402254.2

(22) Date de dépôt: 16.09.1993

(54) Sonde pour la détection et le dosage d'oxygène moléculaire par spectrométrie de résonance paramagnétique électronique

Sonde zur Detektion und Dosierung von molekularen Sauerstoff durch paramagnetische Elektronenresonanz-Spektrometrie

Probe for detection and dosage of molecular oxygen by EPR spectrometry

(84) Etats contractants désignés:
CH DE GB LI

(30) Priorité: 21.09.1992 FR 9211203

(43) Date de publication de la demande:
30.03.1994 Bulletin 1994/13

(73) Titulaire: COMMISSARIAT A L'ENERGIE
ATOMIQUE
75015 Paris (FR)

(72) Inventeurs:
• Moussavi, Mehdi
F-38120 Saint Egreve (FR)
• Beranger, Marc
F-38240 Meylan (FR)

(74) Mandataire: Dubois-Chabert, Guy et al
c/o BREVATOME
25, rue de Ponthieu
75008 Paris (FR)

(56) Documents cités:
EP-A- 0 467 748          US-A- 4 593 248

• SENSORS AND ACTUATORS B vol. B6, no. 1-3 ,
1 Janvier 1992 , LAUSANNE CH pages 266 - 269
D. DURET ET AL. 'OXYGEN CONCENTRATION
MEASUREMENTS USING THE ESR LINE
MODIFICATION OF PcLi MOLECULES'
• MAGNETIC RESONANCE IN MEDICINE. vol. 20,
no. 2 , 1 Août 1991 , DULUTH,MN US pages 333
- 339 H.M. SWARTZ ET AL. 'MEASUREMENTS OF
PERTINENT CONCENTRATIONS OF OXYGEN IN
VIVO'
• SYNTHETIC METALS vol. 52, no. 1 , 15
Septembre 1992 , LAUSANNE, CH pages 57 - 69
F. BENSEBAA ET AL. 'THE EFFECT OF OXYGEN
ON PHTHALOCYANINE RADICALS II.
COMPARATIVE STUDY OF TWO LITHIUM
PHTHALOCYANINE POWDER DERIVATES BY
CONTINUOUS AND PULSED ESR'

## Description

La présente invention se rapporte au domaine de la détection et du dosage de l'oxygène dans une atmosphère à surveiller.

Elle concerne plus particulièrement, mais non exclusivement, la mise en oeuvre, à l'aide d'une sonde appropriée, des méthodes connues de dosage de l'oxygène par spectrométrie de résonance paramagnétique électronique de la molécule de phtalocyanine de lithium dans sa forme particulière cristalline quadratique. Ces méthodes connues ont été décrites notamment dans les documents FR-A-2 664 705 et FR-A-2 664 607.

On rappellera d'abord sommairement qu'une population de spins, nucléaires ou électroniques, se mettent à précesser à une fréquence $F_o = \gamma B_o$ quand on les soumet à une induction magnétique élevée et continue $\overrightarrow{B_o}$, $\gamma$ étant le rapport gyromagnétique caractéristique de la substance en cause. Si de surcroît on soumet cette substance ainsi polarisée, à un champ magnétique de radiofréquence réglable et de direction perpendiculaire à l'induction $\overrightarrow{B_o}$, on observe un phénomène de résonance lorsque cette radiofréquence réglable passe par la valeur $F_o$. Cet état de résonance se traduit par une émission ou une absorption d'énergie passant par des maximums que l'on peut détecter.

Or, la configuration moléculaire de la forme cristalline quadratique de la phtalocyanine de lithium lui permet de piéger sélectivement les molécules d'oxygène $O_2$ et elles seules. La molécule $O_2$ ainsi piégée crée un couplage magnétique qui affecte le signal de résonance paramagnétique électronique de la phtalocyanine et permet son identification spectrométrique, donc par conséquent de détecter la présence et de mesurer la quantité de molécules d'oxygène $O_2$ dans un mélange gazeux baignant un échantillon de phtalocyanine de lithium. De plus, les phtalocyanines utilisées dans le cadre de l'invention, qui sont de type radicalaire, ont cette propriété intéressante selon laquelle la largeur de leur raie de résonance paramagnétique électronique varie de façon pratiquement linéaire avec la teneur en oxygène dans la gamme des concentrations en oxygène s'étendant de O à 10%, ce qui permet facilement un dosage quantitatif.

Les méthodes de détection d'un signal de résonance électronique font partie des connaissances usuelles de l'homme du métier et ne seront donc pas décrites une nouvelle fois ici. Dans le cadre de la présente invention, toute méthode connue peut être appliquée.

On rappellera néanmoins qu'en théorie, le passage par l'état de résonance magnétique peut être provoqué aussi bien par balayage de l'induction de polarisation $\overrightarrow{B_o}$ que par variation de la fréquence du champ d'excitation. C'est la première méthode qui sera décrite dans la suite du présent texte, mais il doit bien être entendu que c'est là une option faite à titre non limitatif.

Bien que le principe de la détection d'oxygène moléculaire par résonance paramagnétique électronique par la phtalocyanine de lithium soit connu depuis les documents FR-A-2 664 705 et FR-A-2 664 607, aucune réalisation d'un appareil industriel n'a vu le jour depuis cette date, en raison des difficultés de conception d'une sonde opérationnelle, notamment en ce qui concerne l'introduction de la phtalocyanine de lithium dans l'atmosphère à surveiller, cette introduction devant être compatible avec la possibilité de la soumettre de façon très précise aux inductions magnétiques nécessaires à la production et à la détection du phénomène de résonance paramagnétique électronique. Or, comme on le sait, les aimants et bobines utilisés à cet effet sont très délicats à construire et en général très coûteux.

Le document Sensors and Actuators B, 6 (1992), pages 266-269, décrit une sonde pour la détection d'oxygène moléculaire dans une atmosphère par spectrométrie de résonance paramagnétique électronique d'un échantillon de phtalocyanine de lithium mis en contact avec l'atmosphère à surveiller, comprenant: une tubulure en verre parcourue par un flux de l'atmosphère à surveiller, au centre de laquelle une chambre à parois poreuses, traversée par le flux précédent, renferme l'échantillon de phtalocyanine et est entourée par la bobine d'excitation et de détection de la résonance électronique; et un aimant ayant une carcasse magnétique de forme générale tubulaire cylindrique allongée dont le conduit central a une forme et des dimensions qui lui permettent de venir s'adapter autour de ladite tubulure, cet aimant muni d'un bobinage permettant de créer le champ continu de polarisation de l'échantillon de phtalocyanine de lithium.

La présente invention a pour objet une sonde pour la détection et le dosage de l'oxygène moléculaire par spectrométrie de résonance électronique de la phtalocyanine de lithium qui résout de façon simple les problèmes précédents tout en étant d'une application facile dans l'industrie.

Selon la revendication 1, cette sonde comprend :

- au moins une tubulure fixe en verre, de forme générale en épingle à cheveux, parcourue par un flux de l'atmosphère à surveiller, au sommet de laquelle une chambre à parois poreuses, traversée par le flux précédent, renferme l'échantillon de phtalocyanine et est entourée par les spires de la bobine d'excitation et de détection de la résonance électronique ;
- un aimant amovible ayant une carcasse magnétique de forme générale tubulaire cylindrique allongée dont le conduit central a une forme et des dimensions qui lui permettent de venir s'adapter autour de la tubulure précédente qu'il coiffe alors complètement, cet aimant amovible étant muni de bobinages permettant de créer, perpendiculairement au champ de la bobine d'excitation précédente, le champ continu $\overrightarrow{B_o}$ de polarisation de l'échantillon de phtalocyanine de lithium et le champ oscillant de balayage de cette polarisation $B_o$ pour re-

chercher l'état de résonance.

D'après la définition qui précède, les deux caractéristiques essentielles de la sonde objet de l'invention résident d'une part dans le fait de faire la mesure dans un flux de l'atmosphère à contrôler, l'échantillon de phtalocyanine de lithium étant piègé au sein de ce flux dans une chambre à parois poreuses traversée par ce même flux et d'autre part dans la conception amovible de l'aimant de polarisation et de balayage qui par sa forme particulière peut servir de logement à la tubulure en verre. La chambre à paroi poreuse réalise, ce qu'il n'était pas facile de faire, le maintien en place en un lieu fixe de l'échantillon de phtalocyanine tout en lui permettant d'être traversé en permanence par le flux d'atmosphère à surveiller. Par ailleurs, le caractère amovible de l'aimant permet, dans une installation de type industriel où l'on souhaite par exemple mesurer le taux d'oxygène en plusieurs endroits d'un écoulement gazeux, de n'utiliser qu'un seul aimant pour plusieurs tubulures en verre fixées à divers endroits d'un trajet gazeux. Il en résulte un avantage économique substantiel puisque comme on l'a rappelé précédemment, l'aimant de polarisation est une pièce délicate à fabriquer et donc extrêmement coûteuse.

Selon un mode de mise en oeuvre particulièrement intéressant, la chambre à parois poreuses renfermant l'échantillon de phtalocyanine de lithium est en verre fritté.

Selon une autre caractéristique également intéressante de l'invention, les deux branches d'entrée et de sortie de la tubulure en verre sont raccordées à une pièce en acier inoxydable massif comportant une conduite creuse pour l'écoulement du gaz constituant l'atmosphère à tester et deux tubulures de sortie et d'entrée également en acier inoxydable auxquelles sont précisément soudées les deux branches de la tubulure en verre. Cette pièce en acier inoxydable massif, utilisée pour l'amener de l'atmosphère à surveiller dans la tubulure de verre, est également utilisable, à l'aide de vis et de taraudages, pour assurer la fixation précise de l'aimant de polarisation autour de la tubulure puisque celle-ci est soudée de façon fixe à cette pièce.

Enfin selon une autre caractéristique également importante de la présente invention, le bobinage de polarisation et de balayage est réparti en plusieurs sections le long de la paroi de la carcasse magnétique de façon à ce que son centre de gravité soit situé dans la chambre à parois poreuses et qu'il crée un champ homogène dans toute cette chambre.

Cette disposition permet une grande souplesse dans l'élaboration de l'induction magnétique de polarisation et de balayage puisque c'est la répartition des spires de la bobine dans les différentes sections de la paroi de la carcasse magnétique qui permet d'obtenir à l'endroit exact voulu un champ homogène sur une dimension au moins égale à celle de la chambre à parois poreuses contenant la phtalocyanine. Les formes et dimensions de ces bobines peuvent être déduites de l'article de L.B. Lugansky, "On Optical Synthesis of Magnetic Fields", Journal of Physics, 1, 53 (1990).

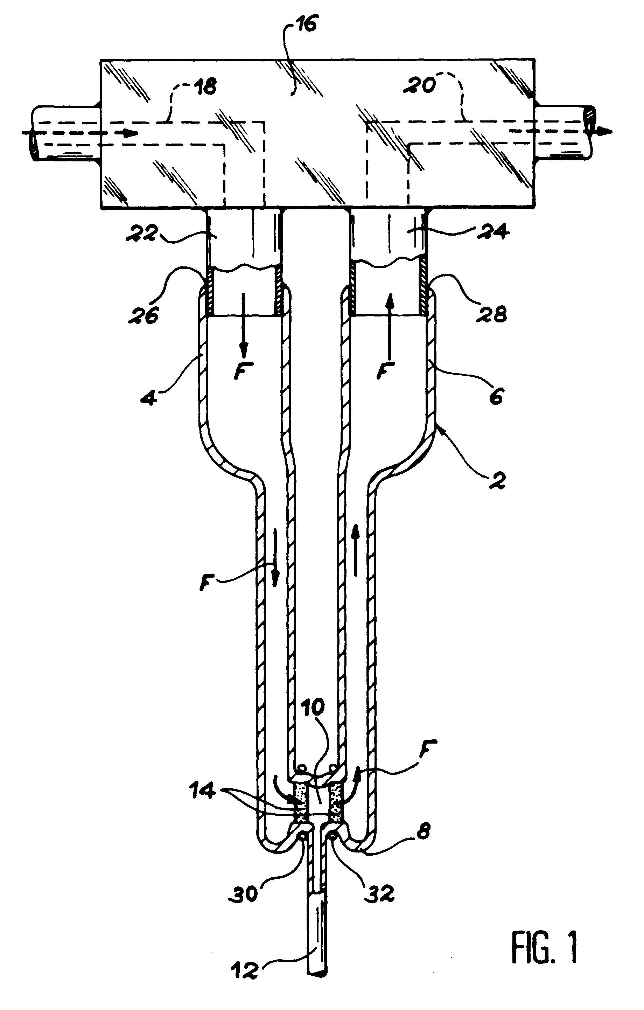

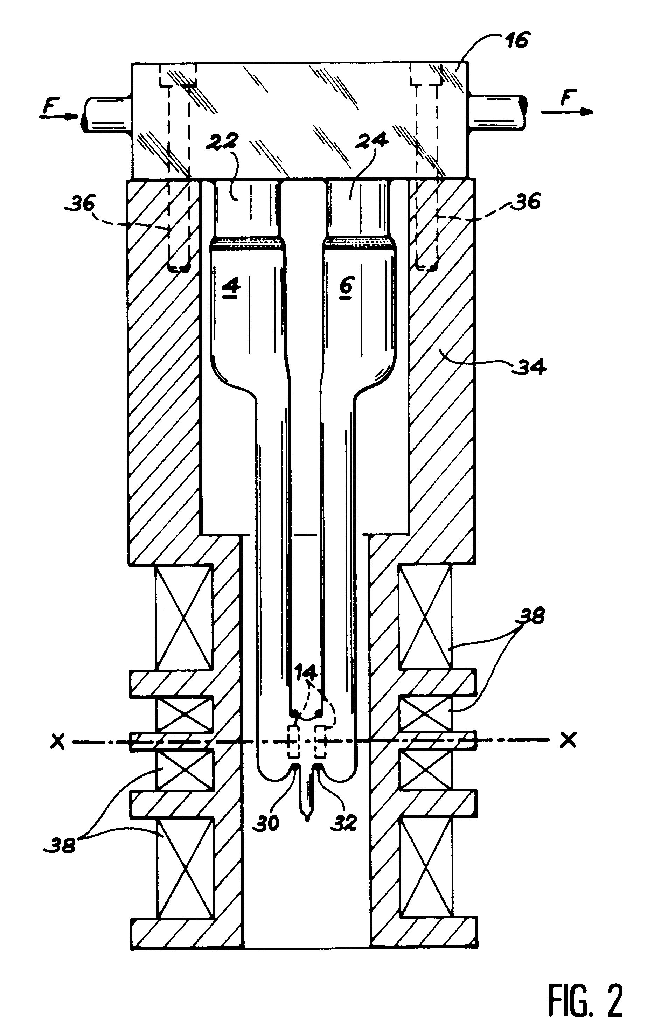

De toute façon la présente invention sera mieux comprise en se référant à la description qui suit d'un exemple donné à titre illustratif et non limitatif de la sonde objet de l'invention. Cette description sera faite en se référant aux figures 1 et 2 ci-jointes, sur lesquelles :

- la figure 1 représente la tubulure de verre fixée sur sa pièce d'acier inoxydable massif ;
- la figure 2 représente la même pièce mais coiffée cette fois de l'aimant de polarisation fixé à sa partie supérieure à la pièce d'acier inoxydable massif.

Sur la figure 1, on voit la tubulure de verre 2 dont la forme générale est celle d'une épingle à cheveux avec une branche d'entrée 4, une branche de sortie 6 et un sommet 8 dans lequel est précisément située la chambre à parois poreuses 10. A la partie inférieure de la figure 1 est représenté un queusot 12 qui sert à l'introduction de la phtalocyanine de lithium dans la chambre 10, après quoi il est fermé définitivement.

Dans la tubulure de verre 2, l'atmosphère que l'on veut surveiller circule selon la direction des flèches F en traversant les parois 14 en verre fritté de la chambre à parois poreuses. A la partie supérieure de la figure 1 est représentée la pièce en acier inoxydable massif 16 qui sert de support à la fois à la tubulure de verre 2 et comme on le verra sur la figure 2 suivante, à l'aimant de polarisation. Cette pièce en acier inoxydable massif comporte une conduite creuse 18 pour l'entrée de l'atmosphère à surveiller dans la tubulure 2 et une conduite creuse 20 pour la sortie vers l'extérieur du flux de cette même atmosphère. Deux tubulures, l'une d'entrée 22 et l'autre de sortie 24, font également partie de la pièce massive 16 et sont comme elle en acier inoxydable. Le raccordement de la tubulure 2 à ces tubulures 22 et 24 a lieu par des soudures schématisées sur le dessin en 26 et 28.

Enfin, la bobine servant à l'excitation de la phtalocyanine de lithium et à la détection de la raie de résonance paramagnétique électronique, est constituée de deux spires entourant la chambre à parois poreuses 10 et visibles sur la figure en 30 et 32. Cette bobine étant ainsi fixée au sommet de la tubulure de verre à proximité immédiate de la chambre 10 à parois poreuses permet facilement l'excitation de l'échantillon de phtalocyanine de lithium que pour plus de clarté l'on a pas représenté dans la chambre 10 sur la figure 1. L'utilisation de la bobine unique pour l'excitation et la détection a déjà été signalé par A. Abragam dans "Les Principes du Magnétisme Nucléaire" pages 78 à 80.

Sur la figure 2 on retrouve tous les éléments de la figure 1 portant les mêmes nombres de référence. Cette figure 2 toutefois, correspond à la situation dans laquelle l'aimant de polarisation et de balayage 34 est fixé autour de la tubulure en verre 2 qu'il vient enfermer à la manière d'une coiffe. Cet aimant 34 est fixé à la pièce en acier inoxydable massif 16 par un système de vis et de taraudages 36 et c'est à la partie inférieure du dessin de la figure 2 que se trouvent réparties en quatre sections, les bobinages 38 de polarisation et de balayage de l'induction de polarisation $B_o$ nécessaire au déclenchement du phénomène de polarisation et de résonance paramagnétique électronique des cristaux de phtalocyanine de lithium situés au sommet de la tubulure de verre 2. Le bobinage 38 précédent est effectivement réparti en quatre sections de façon symétrique par rapport au plan XX de la figure 2 de façon à créer comme on l'a précédemment expliqué, une induction magnétique aussi homogène que possible dans tout le volume de la chambre à parois poreuses 10.

L'un des grands avantages de la sonde, objet de l'invention réside précisément dans le fait que l'aimant de polarisation et de balayage 34 étant facilement désolidarisable de la pièce en acier inoxydable massif 16, on peut concevoir dans une installation industrielle, la présence de plusieurs tubulures de verre comparables à celles de la figure 1 situées en des endroits différents et néanmoins utilisables pour des mesures de détection et de dosage d'oxygène par le simple fait que l'on vient y adapter à tour de rôle un seul et même aimant de polarisation 34.

## Revendications

1. Sonde pour la détection et le dosage d'oxygène moléculaire dans une atmosphère par spectrométrie de résonance paramagnétique électronique d'un échantillon de phtalocyanine de lithium mis en contact avec l'atmosphère à surveiller, comprenant :

   - au moins une tubulure fixe en verre (2), de forme générale en épingle à cheveux, parcourue par un flux de l'atmosphère à surveiller, au sommet (8) de laquelle une chambre à parois poreuses (10), traversée par le flux précédent, renferme l'échantillon de phtalocyanine et est entourée par les spires (30,32) de la bobine d'excitation et de détection de la résonance électronique ;
   - un aimant amovible (34) ayant une carcasse magnétique de forme générale tubulaire cylindrique allongée dont le conduit central a une forme et des dimensions qui lui permettent de venir s'adapter autour de la tubulure (2) précédente qu'il coiffe alors complètement, cet aimant amovible (34) étant muni de bobinages (38) permettant de créer, perpendiculairement au champ de la bobine d'excitation (30,32) précédente, le champ continu $\vec{B_o}$ de polarisation de l'échantillon de phtalocyanine de lithium et le champ oscillant de balayage de cette polarisation $\vec{B_o}$ pour rechercher l'état de résonance.

2. Sonde selon la revendication 1, caractérisé en ce que la chambre à parois poreuses (10) renfermant l'échantillon de phtalocyanine de lithium est en verre fritté.

3. Sonde selon l'une des revendication 1 et 2, caractérisé en ce que les deux branches d'entrée (4) et de sortie (6) de la tubulure en verre (2) sont raccordées à une pièce en acier inoxydable massif (16) comportant une conduite creuse (18,20) pour l'écoulement du gaz constituant l'atmosphère à tester et deux tubulures de sortie (22) et d'entrée (24) également en acier inoxydable auxquelles sont précisément soudées les deux branches (4,6) de la tubulure en verre (2).

4. Sonde selon l'une quelconque des revendications 1 à 3 précédentes, caractérisée en ce que le bobinage (38) de polarisation et de balayage est réparti en plusieurs sections le long de la paroi de la carcasse magnétique de façon à ce que son centre de gravité soit situé dans la chambre à parois poreuses (10) et qu'il crée un champ homogène dans toute cette chambre.

## Claims

1. Probe for detecting and dosing molecular oxygen in an atmosphere by means of the electronic paramagnetic resonance spectrometry of a lithium phthalocyanine sample placed in contact with the atmosphere to be tested, comprising:

   - at least one fixed glass tube (2) with the general shape of a hairpin traversed by a flow of the atmosphere to be tested and at the top (8) of which a chamber (10) with porous walls traversed by said flow contains the phthalocyanine sample and is surrounded by the spires (30, 32) of the coil for exciting and detecting the electronic resonance;
   - a movable magnet (34) having a magnetic frame with a general elongated cylindrical tubular shape whose central pipe has a shape and dimensions enabling it to be adapted around said tube (2) which it then covers completely, said movable magnet (34) being provided with windings (38) making it possible to create perpendicular to the field of said excitation coil (30, 32) the continuous field $\vec{Bo}$ for polarizing the lithium phthalocyanine sample and the oscillating field scanning this polarization $\vec{Bo}$ in order to find the state of resonance.

2. Probe according to claim 1, characterized in that the chamber (10) with porous walls containing the lithium phthalocyanine sample is made of sintered glass.

**3.** Probe according to claim 1 or 2, characterized in that the two inlet (4) and outlet (6) branches of the glass tube (2) are connected to a solid stainless steel piece (16) comprising a hollow pipe (18, 20) for the flowing of the gas constituting the atmosphere to be tested, and two inlet (22) and outlet (24) tubes, also made of solid stainless steel, are welded permanently to the two branches (4, 6) of the glass tube (2).

**4.** Probe according to any one of the claims 1 to 3, characterized in that the scanning and polarization winding (38) is divided into several sections along the wall of the magnetic frame so that its centre of gravity is situated inside the chamber (10) with porous walls and creates a homogeneous field in the entire chamber.

**Patentansprüche**

**1.** Sonde für den Nachweis und die Bestimmung von molekularem Sauerstoff in einer Atmosphäre durch paramagnetische Elektronenresonanz-Spektrometrie einer Lithiumphthalocyanin-Probe, die mit der zu überwachenden Atmosphäre in Kontakt steht, die umfaßt

- mindestens ein festes, im allgemeinen U-förmiges Glasrohr (2), durch das ein Strom der zu überwachenden Atmosphäre hindurchströmt, an dessen Scheitel (8) eine Kammer mit porösen Wänden (10), die von dem obengenannten Strom durchströmt wird, die Phthalocyanin-Probe enthält und von Windungen (30, 32) der Erreger- und Elektronenresonanz-Nachweisspule umgeben ist; und
- einen abnehmbaren (beweglichen) Magneten (34), der eine im allgemeinen rohrförmige zylindrische langgestreckte magnetische Karkasse aufweist, deren zentrale Rohrleitung eine Form und Dimensionen hat, die es ihr erlauben, sich an das obengenannte Rohr (2) so anzupassen, daß es dieses dann vollständig bedeckt, wobei dieser abnehmbare (bewegliche) Magnet (34) mit Wicklungen (38) ausgestattet ist, welche die Erzeugung eines Polarisations-Gleichfeldes $\vec{B_o}$ der Lithiumphthalocyanin-Probe und eines oszillierenden Abtast-Feldes dieser Polarisation $\vec{B_o}$ senkrecht zu dem Feld der obengenannten Erregerspule (30, 32) erlauben, um den Resonanz Zustand zu ermitteln.

**2.** Sonde nach Anspruch 1, dadurch gekennzeichnet, daß die Kammer mit porösen Wänden (10), welche die Lithiumphthalocyanin-Probe enthält, aus Sinterglas besteht.

**3.** Sonde nach einem der Ansprüche 1 und 2, dadurch gekennzeichnet, daß die beiden Eintritts- und Austritts-Schenkel (4, 6) des Glasrohres (2) mit einem Element aus massivem nicht oxidierbarem Stahl (16) verbunden sind, das eine hohle Leitung (18, 20) aufweist, in der das die zu untersuchende Atmosphäre aufbauende Gas fließt, und das zwei Austritts- und Eintritts-Rohre (22, 24) aufweist, die ebenfalls aus nicht oxidierbarem Stahl bestehen, an die die beiden Schenkel (4, 6) des Glasrohres (2) genau angeschweißt sind.

**4.** Sonde nach einem der vorhergehenden Ansprüche 1 bis 3, dadurch gekennzeichnet, daß die Polarisations- und Abtast-Spule (38) in mehreren Abschnitten entlang der Wand der magnetischen Karkasse so verteilt ist, daß ihr Gravitationszentrum in der Kammer mit porösen Wänden (10) angeordnet ist und daß sie in der gesamten Kammer ein homogenes Feld erzeugt.

FIG. 1

FIG. 2